(19) Europäisches Patentamt
European Patent Office
Office européen des brevets

(11) **EP 1 797 599 B1**

(12) **EUROPÄISCHE PATENTSCHRIFT**

(45) Veröffentlichungstag und Bekanntmachung des Hinweises auf die Patenterteilung:
**06.05.2009 Patentblatt 2009/19**

(51) Int Cl.:
***H01L 39/16*** *(2006.01)*     ***H02H 9/02*** *(2006.01)*

(21) Anmeldenummer: **05787075.0**

(22) Anmeldetag: **27.09.2005**

(86) Internationale Anmeldenummer:
**PCT/EP2005/054852**

(87) Internationale Veröffentlichungsnummer:
**WO 2006/037741 (13.04.2006 Gazette 2006/15)**

(54) **SUPRALEITENDE STROMBEGRENZEREINRICHTUNG VOM RESISTIVEN TYP MIT BANDFÖRMIGER HOCH-TC-SUPRALEITERBAHN**

RESISTIVE TYPE SUPERCONDUCTIVE CURRENT-LIMITING DEVICE COMPRISING A STRIP-SHAPED HIGH-TC-SUPERCONDUCTIVE PATH

LIMITEUR DE COURANT SUPRACONDUCTEUR DE TYPE RESISTIF COMPORTANT UNE PISTE SUPRACONDUCTRICE A TC ELEVEE EN FORME DE BANDE

(84) Benannte Vertragsstaaten:
**AT BE BG CH CY CZ DE DK EE ES FI FR GB GR HU IE IS IT LI LT LU LV MC NL PL PT RO SE SI SK TR**

(30) Priorität: **04.10.2004 DE 102004048646**

(43) Veröffentlichungstag der Anmeldung:
**20.06.2007 Patentblatt 2007/25**

(73) Patentinhaber: **SIEMENS AKTIENGESELLSCHAFT**
**80333 München (DE)**

(72) Erfinder:
• **KRÄMER, Hans-Peter**
  **91058 Erlangen (DE)**
• **SCHMIDT, Wolfgang**
  **91056 Erlangen (DE)**

(56) Entgegenhaltungen:
| | |
|---|---|
| **EP-A- 0 417 329** | **EP-A- 0 444 702** |
| **EP-A- 0 911 889** | **WO-A-00/10208** |
| **WO-A-99/33122** | **US-A- 3 363 207** |

**Beschreibung**

Die Erfindung bezieht sich auf eine supraleitende Strombegrenzereinrichtung vom resistiven Typ, deren Leiterbahn mit einem bandförmigen Supraleiteraufbau gebildet ist, dessen oxidisches Hoch-$T_c$-Supraleitermaterial vom Typ $AB_2Cu_3O_x$, als Schicht auf einem Substratband aus einem normalleitendem Substratmetall aufgebracht ist. Dabei sind A mindestens ein Seltenes Erdmetall einschließlich Yttrium und B mindestens ein Erdalkalimetall. Der Supraleiteraufbau der bekannten Strombegrenzereinrichtung enthält wenigstens eine zwischen dem Substratband und der supraleitenden Schicht angeordnete Pufferschicht aus einem oxidischen Puffermaterial, und die Leiterbahn der supraleitenden Strombegrenzereinrichtung ist als eine bifilare Spule ausgebildet ist, wobei zwischen benachbarten Spulenwindungen wenigstens ein für ein Kühlmittel transparenter Abstandshalter angeordnet ist. Dabei ist zwischen benachbarten Spulenwindungen ein Abstand eingehalten, der von dem Kühlmittel durchströmbar ist, und der Supraleiteraufbau enthält eine auf der supraleitenden Schicht) aufgebrachte Deckschicht aus einem normalleitenden Deckmetall. Die Supraleiterschicht und das substrat band sind über Verbindungsteile elektrisch parallel geschaltet. Eine entsprechende Strombegrenzereinrichtung geht aus der WO 99/33122 hervor.

Seit 1986 sind supraleitende Metalloxidverbindungen mit hohen Sprungtemperaturen $T_c$ von über 77 K bekannt, die deshalb auch als Hoch-$T_c$-Supraleitermaterialien oder HTS-Materialien bezeichnet werden und insbesondere eine, Flüssig-Stickstoff ($LN_2$)-Kühltechnik erlauben. Unter solche Metalloxidverbindungen fallen insbesondere Cuprate auf Basis spezieller Stoffsysteme wie z.B. vom Typ $AB_2Cu_3O_x$, wobei A zumindest ein Seltenes Erdmetall einschließlich Yttrium und B mindestens ein Erdalkalimetall sind. Hauptvertreter dieses Stoffsystems vom sogenannten 1-2-3-HTS-Typ ist das sogenannte YBCO ($Y_1Ba_2Cu_3O_x$ mit $6,5 \leq x \leq 7$).

Dieses bekannte HTS-Material versucht man, auf verschiedenen Substraten für unterschiedliche Anwendungszwecke abzuscheiden, wobei im Allgemeinen nach möglichst phasenreinem Supraleitermaterial getrachtet wird. So werden insbesondere metallische Substrate für Leiteranwendungen vorgesehen (vgl. z.B. EP 0 292 959 A1).

Bei der aus der eingangs genannten WO-A-Schrift zu entnehmenden Strombegrenzereinrichtung mit den eingangs genannten Merkmalen sind Isolierbänder vorgesehen, welche zwischen benachbarten Spulenwindungen eingelegt sind. Aufgrund einer gewellten oder gerippten Struktur dieser Isolierbänder wird auch ein Zutritt eines Kühlmittels an die die Spulenwindungen erleichtert. Der Aufbau aus Spulenwindungen und eingelegten Isolierbänder ist jedoch mechanisch nicht hinreichend stabil.

Auch bei einer aus der EP 0 503 448 A zu entnehmenden Strombegrenzereinrichtung wird u.a. ein Typ eines bandförmigen Supraleiters verwendet, der ein Substrat aufweist, das mit einer Beschichtung aus dem HTS-Material versehen ist. Zur Ausbildung der Strombegrenzereinrichtung kann dieser Leiteraufbau als bifilare Spule gewickelt werden, wobei für den Aufbauvorgang zwischen zwei aufeinander folgenden Leiterabschnitten bzw. Spulenwindungen jeweils ein bandförmiger Abstandshalter angeordnet wird. Diese bifilare Spule soll dann auf einer porösen oder mit einer Vielzahl von Löchern versehenen Grundplatte gehalten werden. Nach der Befestigung der Spule auf dieser Grundplatte werden schließlich die zwischen den Leiterabschnitten angeordneten Abstandshalter wieder entfernt. Wegen der Beabstandung der einzelnen Spulenwindungen und der Porosität der Grundplatte ergeben sich so zwischen den Spulenwindungen Strömungswege für ein das supraleitende Material kühlendes Kühlmittel.

Aus der WO 00/10208 ist ein elektrisch stabilisierter Dünnschicht-HTS-Leiter zu entnehmen, mit dem auch eine Strombegrenzereinrichtung herzustellen ist. Der Aufbau dieses HTS-Leiters weist eine auf einem flächigen metallischen Substrat aufgebrachte HTS-Schicht auf, die von einer isolierenden Pufferschicht abgedeckt ist. Ferner ist auf dieser Pufferschicht eine elektrisch leitende Leitschicht abgeschieden; die mit der HTS-Schicht an diskreten, lochartigen Stellen durch die Pufferschicht hindurch kontaktiert ist. Es sind keine näheren Einzelheiten zur Herstellung einer Strombegrenzereinrichtung angegeben.

Aufgabe der vorliegenden Erfindung ist es, diese Strombegrenzereinrichtung mit den eingangs genannten Merkmalen dahingehend zu verbessern, dass ihr Aufbau weniger aufwendig ist und dennoch eine hinreichende mechanische Stabilität dieses Aufbaus zu erreichen ist.

Diese Aufgabe wird mit den in Anspruch 1 angegebenen Maßnahmen gelöst. Demgemäß soll der Supraleiteraufbau der Strombegrenzereinrichtung mit den eingangs genannten Merkmalen eine auf der supraleitenden Schicht aufgebrachte Deckschicht aus einem normalleitenden Deckmetall enthalten, wenigstens eine elektrische Kontaktierung zwischen der Deckschicht und dem Substratband vorgesehen sein und die Spule mit dem Supraleiter und dem wenigstens einen Abstandshalter eigenstabil ausgebildet sein, indem eine Verklebung zwischen diesen Teilen in gegenseitigen Berührungsbereichen vorgesehen ist.

Die mit dieser Ausbildung der Strombegrenzereinrichtung verbundenen Vorteile sind insbesondere darin zu sehen, dass der Wickel der bifilaren Spulen zusammen mit dem Abstandshalter in einem gemeinsamen Arbeitsgang erstellt werden kann. Der Aufbau der Spule ist dementsprechend einfach. Außerdem ist wegen der Verwendung der normalleitenden Deckschicht eine Kontaktierung des Supraleiters an den Enden des Wickels problemlos vorzunehmen. Eines besonderen Trägerkörpers für die Spule zu deren mechanischer Verstärkung bedarf es dabei nicht.

In Hinblick auf eine hinreichend eigenstabile Ausbildung der Spule werden bei der Strombegrenzereinrichtung nach der Erfindung vorteilhaft deren Supraleiter zusammen mit dem Abstandshalter z.B. mittels eines Kunstharzes unter Freihaltung der erforderlichen Kühlmittelwege miteinander verklebt. Die verklebung erfolgt dabei zweckmäßig nur in den gegenseitigen Berührungsbereichen dieser Teile, so dass eine hinreichende Kühlung des supraleitenden Materials zu gewährleisten ist.

Vorteilhafte Ausgestaltungen der Strombegrenzereinrichtung nach der Erfindung gehen aus den Unteransprüchen hervor. Dabei können deren Merkmale auch in Kombination miteinander in Ansatz gebracht werden.

So ist es besonders vorteilhaft, wenn in der Spule der Supraleiter mit seiner Substratbandseite nach außen angeordnet ist.

Außerdem kann in der Spule zwischen dem Abstandshalter und dem jeweils benachbarten Substratband des Supraleiters bzw. der Spulenwindung eine Isolationsfolie angeordnet sein.

Bevorzugt lässt sich ein Abstandshalter verwenden, der als wenigstens eine wellenförmige Abstandsfolie ausgebildet ist. Mit solchen Abstandsfolien sind auf einfache Weise Strömungswege für das Kühlmittel auszubilden.

Für die Gewährleistung eines hinreichenden Querschnitts für eine Kühlmittelströmung sollte der gegenseitige Abstand der Spulenwindung) mindestens 1 mm betragen.

Als besonders vorteilhaft ist es anzusehen wenn wenigstens ein Kontaktierungselement aus einem normalleitenden Kontaktierungsmaterial zumindest an einer Längsseite des Aufbaus des Supraleiters zwischen dessen Deckschicht und seinem Substratband) vorgesehen wird, wobei für den normalleitenden Begrenzungszustand der Strombegrenzereinrichtung die Beziehung gelten sollte:

$$R_K > 3 \cdot R_L \text{, vorzugsweise } R_K > 10 \cdot R_L$$

mit $R_L$ als dem elektrischen Widerstand des Aufbaus ohne Kontaktierungselement über die Gesamtlänge der Leiterbahn und mit $R_K$ als dem Widerstand des wenigstens einem Kontaktierungselementes über die Gesamtlänge. Dabei ist als Gesamtlänge die für den Schaltvorgang zwischen Supraleitung und Normalleitung der Strombegrenzereinrichtung zur Verfügung stehende Länge des bandförmigen Supraleiters zu verstehen. Der Widerstand $R_L$ setzt sich dabei aus einer Parallelschaltung des Widerstandes des Substratbandes, der Deckschicht sowie des maximal möglichen normalleitenden Widerstandes der supraleitenden Schicht zusammen. Werden mehrere Kontaktierungselemente vorgesehen, so bilden diese ebenfalls eine Parallelschaltung mit einem Gesamtwiderstand vom Wert $R_K$. Dieser Wert lässt sich in bekannter Weise durch die Materialwahl für das wenigstens eine Kontaktierungselement bzw. des elektrischen spezifischen Widerstandes p seines Materials sowie durch die Dicke bzw. den zur Verfügung gestellten leitenden Querschnitts einstellen.

Die mit dieser Ausbildung der Strombegrenzereinrichtung verbundenen Vorteile sind insbesondere darin zu sehen, dass das metallische Substratband und die normalleitende Deckschicht und damit auch die mit ihr galvanisch verbundene supraleitende Schicht in Stromführungsrichtung gesehen zumindest in den Teilbereichen entlang der Länge des Aufbaus im gegenseitigen elektrischen Kontakt gebracht sind und somit auf einem einzigen elektrischen Potential auch im Falle eines Quenches liegen. Auf diese Weise wird ein Durchschlag über die Pufferschicht unterbunden.

Zu dieser Ausgestaltung der Strombegrenzereinrichtung können insbesondere noch folgende Maßnahmen im Einzelnen oder auch in Kombination zusätzlich vorgesehen werden:

- Im Allgemeinen liegt die durchschnittliche Dicke des wenigstens einen Kontaktierungselementes unter 1 $\mu$m, vorzugsweise unter 0,5 $\mu$m. Vorteilhaft reichen nämlich für eine hinreichende galvanische Verbindung entsprechend dünne Schichten aus, da mit ihnen nur eine galvanische Verbindung, jedoch keine Führung größerer Ströme erfolgt.
- Als Material für das wenigstens eine Kontaktierungselement kann insbesondere Au oder Ag oder Cu oder eine Legierung mit dem jeweiligen Element oder wenigstens einem weiteren Legierungspartner vorgesehen sein. Entsprechende Kontaktierungselemente können beispielsweise durch Lötverfahren an den Längsseiten des Leiteraufbaus angebracht oder mittels des Lotmaterials erzeugt sein. Da nur an den Seiten gelötet zu werden braucht, ist die Gefahr einer Schädigung des HTS-Materials entsprechend gering.
- Besonders vorteilhaft kann das Kontaktierungselement als ein den Leiteraufbau allseitig umschließendes Umhüllungselement ausgebildet sein, wobei ein solches Umhüllungselement als eine galvanische Beschichtung ausgebildet sein kann. Solche Beschichtungen sind, da nur eine geringe Dicke erforderlich ist, auf besonders einfache und für das HTS-Material schonende Weise zu erstellen.

Statt einer Ausbildung besonderer Kontaktierungselemente kann bei der Strombegrenzereinrichtung zumindest in Teilbereichen wenigstens eine der Seitenkanten des Leiteraufbaus so mechanisch deformiert werden, dass sich die Deckschicht und das Substratband in elektrischem Kontakt befinden. Die mit dieser Ausbildung der Strombegrenzervorrichtung verbundenen Vorteile sind insbesondere darin zu sehen, dass das metallische Substratband und die normalleitende Deckschicht und damit auch die mit ihr galvanisch verbundene supraleitende Schicht in Stromführungsrichtung gesehen zumindest in den Teilbereichen entlang der Länge des Aufbaus im gegenseitigen elektrischen Kontakt gebracht sind und somit auf einem einzigen elektrischen Potential auch im Falle eines Quenches liegen. Auf diese Weise wird ein Durchschlag über die Pufferschicht unterbunden. Eine entsprechende Deformation an wenigstens einer der Längsseiten des Leiteraufbaus ist insofern vertretbar, als im Normalfall die supraleitenden Eigenschaften der supraleitenden Schicht an den seitlichen Rändern sowieso herstellungsbedingt verschlechtert sind. Dabei lässt sich der elektrische Kontakt an der wenigstens einen Seitenkante durch eine Quetsch- oder Walzverformung bilden Entsprechende Verformungen sind leicht auszuführen.

Um einen elektrischen Durchschlag über die wenigstens eine Pufferschicht zwischen der Deckschicht mit der supraleitenden Schicht einerseits und dem metallischen Substratband andererseits zu verhindern, können diese Teile auf dasselbe Potential auch dadurch gelegt werden, dass man für das Material der Pufferschicht zumindest in Teilbereichen ein Material mit einer hierfür hinreichenden elektrischen Leitfähigkeit wählt. Vorteilhaft wird hierzu ein solches gewählt, dass ein Übergangswiderstand zwischen supraleitender Schicht und Substratband von höchstens $10^{-3}\ \Omega\cdot cm^2$, vorzugsweise von höchstens $10^{-5}\ \Omega\cdot cm^2$, ausgebildet ist. Zur Einhaltung dieser Bedingung kann bevorzugt das Material der Pufferschicht einen mittleren spezifischen Widerstand von höchstens $5000\ \mu\Omega\cdot cm$, vorzugsweise von höchstens $500\ \mu\Omega\cdot cm$, aufweisen. Hierfür besonders geeignete Materialien sind solche vom Typ La-Mn-O oder Sr-Ru-O oder La-Ni-O oder In-Sn-O.

Weitere vorteilhafte Ausgestaltungen der Strombegrenzereinrichtung nach der Erfindung gehen aus den vorstehend nicht angesprochenen Unteransprüchen hervor.

Zur weiteren Erläuterung der Erfindung wird nachfolgend auf die Zeichnung Bezug genommen, an Hand derer bevorzugte Ausführungsbeispiele von Strombegrenzereinrichtungen erläutert sind. Dabei zeigen jeweils in stark schematisierter Form

| | |
|---|---|
| deren Figur 1 | den bifilaren Aufbau einer Scheibenspule der Strombegrenzereinrichtung sowie ein Detail aus dieser jeweils in Aufsicht, |
| deren Figur 2 | die Verschaltung mehrerer solcher Scheibenspulen zu einer 3-phasigen Anordnung in Schrägansicht, |
| deren Figur 3 | den Aufbau eines YBCO-Bandleiters für eine Scheibenspule nach Figur 1 oder 2 in Schrägansicht, |
| deren Figur 4 | eine zweite Ausführungsform des Aufbaus eines YBCO-Bandleiters für eine Scheibenspule nach Figur 1 oder 2 in Querschnittsansicht sowie |
| deren Figur 5 | eine zu dem Aufbau nach Figur 4 alternative Ausführungsform eines YBCO-Bandleiters in entsprechende Ansicht. |

Dabei sind in den Figuren sich entsprechende Teile jeweils mit denselben Bezugszeichen versehen.

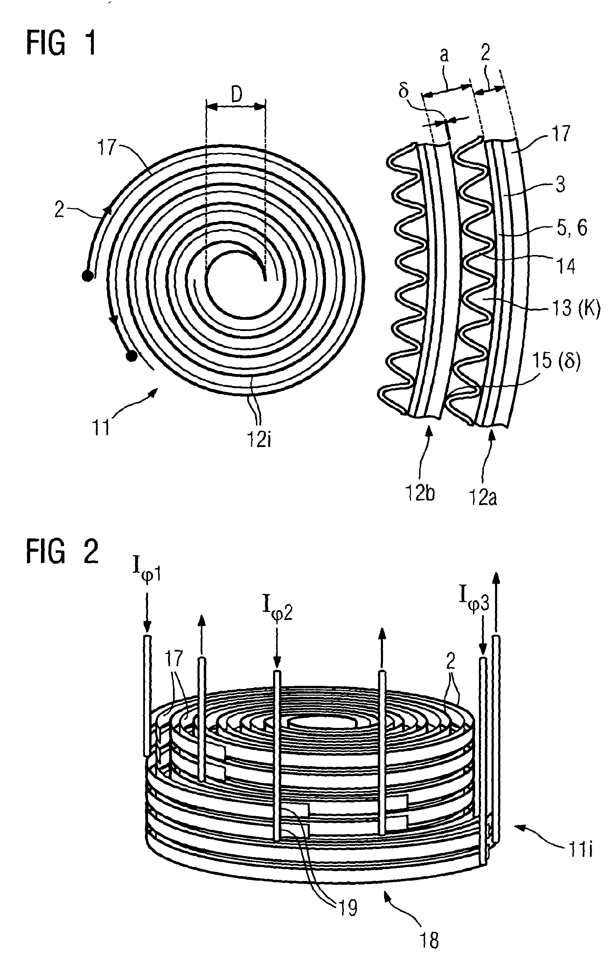

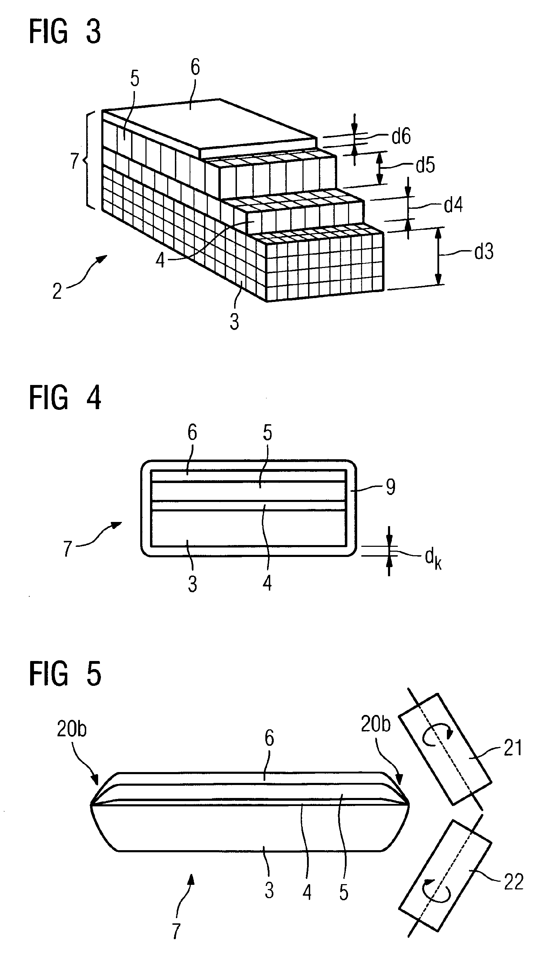

In Figur 1 sind die wesentlichsten Teile eines Aufbaus einer allgemein mit 11 bezeichneten Spule einer erfindungsgemäßen Strombegrenzereinrichtung sowie in vergrößerter Darstellung ein Detail aus dieser Spule veranschaulicht. Dabei ist die Spule eigenstabil mit einem YBCO-Bandleiter 2 ausgebildet, von dem bevorzugte Ausführungsformen an Hand der Figuren 3 bis 5 noch erläutert werden. In der Figur sind weiterhin bezeichnet mit 3 ein metallisches Substratband des Bandleiters und mit 5,6 sogenannte Funktionsschichten, gebildet von einer YBCO-Schicht mit darunter befindlicher Pufferschicht und einer auf der YBCO-Schicht befindlichen metallischen Deckschicht. Unter einem eigenstabilen Aufbau der Spule sei ein Aufbau verstanden, der ohne einen besonderen Trägerkörper auskommt, auf dem der Wickel der Spule aus mechanischen Stabilitätsgründen unbedingt aufzubringen ist. Bei dem verwendeten supraleitenden Bandleiter bieten sich nämlich gewickelte Scheibenspulen an mit der Möglichkeit zum Zutritt eines Kühlmittels K zwischen benachbarten Spulen- bzw. Leiterwindungen 12i bzw. 12a, 12b. Um die Induktivität niedrig zu halten, ist die Spule bifilar gewickelt, d.h. der Strom fließt in benachbarten Spulenwindungen oder -lagen gegenläufig. Damit kann maximal die volle Phasenspannung zwischen den beiden äußeren Enden der Spulenwicklung liegen. Deshalb müssen die Spulenwindungen 12i gegenseitig isoliert werden. Hierzu ist z.B. eine Isolation mittels einer Folie 17 geeignet, die einige Millimeter breiter ist als der bandförmige Leiter 2. Außerdem sollen Kühlkanäle 13 vorhanden sein, um einen Zutritt des Kühlmittels K zu ermöglichen. Solche Kanäle können vorteilhaft durch Einwickeln von Abstandshaltern 14 vorzugsweise mit Wellenform zwischen den einzelnen Spulenwindungen erzeugt werden. Der Innendurchmesser der Spule ist durch den zulässigen kleinsten Krümmungsradius für den Bandleiter 2 bestimmt, bei dem der kritische Strom $I_c$ noch nicht degradiert. Mit einem Mindestdurchmesser D des Wickels der Spule 11 in de Größenordnung von 100 mm kann diese Forderung ohne weiteres erfüllt werden. Da die supraleitende YBCO-Schicht des Bandleiters 2 stärker auf Druck belastbar ist als auf Zug, sollte die Schichtseite des Bandleiters zur Innenseite der Spulen zeigen. Selbstverständlich muss der gesamte Wickel der Spule hinreichend mechanisch stabil sein; d.h., er muss bei der Montage des Aktivteils handhabbar sein und muss die beim Sieden des Kühlmittels K auftretenden Kräfte ohne weiteres aufnehmen können. Hierzu kann vorteilhaft der komplette Wickel der Spule durch eine Vakuumimprägnierung mit einem geeigneten Kunstharz vergossen werden, dessen Teile in der Figur mit 15 bezeichnet sind. Das Kunstharz sollte vor dem Aushärten aus den jeweiligen Kühlkanälen 13 herauslaufen können, so dass auf den Oberflächen nur örtlich diskrete dünne Kunstharzbereiche 15 verbleiben, deren jeweilige Dicke δ an den Funktionsschichten 5,6 bzw. an der Isolationsfolie 17 in der Größenordnung zwischen 10 und 100 μm liegt. Diese Kunstharzschicht stellt dabei einen Teil der gegenseitigen Isolation der Spulenwindungen 12i dar.

Mit dem in Figur 1 dargestellten Aufbau erhält man eine eigenstabile Teilspule 11, von denen mehrere gemäß Figur 2 auf einem geeigneten Stützgerüst parallel und seriell verschaltet werden können. Figur 2 zeigt eine entsprechende Verschaltung von mehreren Teilspulen 11i zu einer entsprechenden dreiphasigen Anordnung 18. Zum Verschalten haben sich Lötkontakte bewährt. Die erforderlichen Kontakte 19 können auf die metallische Deckschicht oder auf die Substratseite des Bandleiters gesetzt werden. Auch der Kontakt zwischen ein- und auslaufendem Band am Innenradius der jeweiligen Spule kann durch Verlöten über einige Zentimeter Länge realisiert werden.

Der Leiterabstand a zwischen benachbarten Spulenwindungen 12i wird bestimmt durch die Dicke der Isolationsfolie 17, der Kunstharzschichtbereiche 15, der Materialstärke des Abstandshalters 14 sowie durch die radiale Breite der Kühlkanäle 13. Dabei ist davon auszugehen, dass die Aufheizphase des Leiterwickels im Quenchfall nahezu adiabatisch verläuft; eine freigesetzte Joulesche Wärme von beispielsweise etwa 200 W/cm$^2$ geht dabei im Wesentlichen in den Leiter; über den Siedefilm, der sich etwa 1 ms ausbilden kann, ist dabei wenig Wärme abzuführen. Deshalb beeinflusst der Leiterabstand vor allem die Rückkühlphase. Stehen die Leiter zu dicht, wird zu wenig Flüssigkeit nachgeführt und die Rückkühlzeit verlängert. Im Extremfall eines Leiterwickels ohne Kühlkanäle bliebe nur die Oberfläche der Spule für den Wärmeaustausch. Ein zweiter Gesichtspunkt für die Bemessung des Windungsabstandes a ist die Kraftwirkung durch Expansion der Kühlflüssigkeit beim Verdampfen. Beide Gesichtspunkte, nämlich Strömung im Kühlkanal 13 und Druckaufbau, können mit den erfindungsgemäß vorgesehenen transparenten Abstandshaltern 14 und deren Bemessung ermittelt werden. Sieht man beispielsweise einen YBCO-Bandleiter 2 von 10 mm Breite vor und steht der folienartige Abstandshalter 14 insgesamt 5 mm, d.h. 2,5 mm an jeder Kante, über, dann ergibt sich ein Verhältnis Abstand zu Leiterhöhe = 3 mm/15 mm = 0,2. Da ein Bandwickel bei dem erfindungsgemäßen Aufbau mechanisch verhältnismäßig stabil und somit entsprechend hohen Kräften widersteht, ist ein Leiterabstand von 1 Millimeter möglich. In diesem Fall bleibt für den Kühlkanal 13 noch eine radiale Ausdehnung von etwa 0,6 mm (Leiterband: ca. 0,15 mm; Isolation: ca. 0,2 mm; Harzschicht: ca. 0,05 mm). Es ergibt sich dann ein vorteilhaftes Aspektverhältnis von 0,6 mm/15 mm = 0,04.

Aus den nachfolgenden Figuren 3 bis 5 geht jeweils eine Ausführungsform des Aufbaus eines YBCO-Bandleiters 2 hervor, wie er bevorzugt für die Spule 11 bzw. die Spulenanordnung 18 nach Figur 1 bzw. Figur 2 zu verwendenden ist.

Bei dem in Figur 3 angedeuteten, allgemein mit 2 bezeichneten Bandleiter wird von an sich bekannten Ausführungsformen von sogenannten YBCO-Bandleitern oder "YBCO Coated Conductors" ausgegangen. In der Figur sind bezeichnet mit

3 ein Substratband aus einem normalleitenden Substratmetall der Dicke d3,

4 wenigstens eine darauf aufgebrachte Pufferschicht aus einem oxidischen Puffermaterial der Dicke d4,

5 eine HTS-Schicht aus YBCO der Dicke d5,

6 eine Deckschicht aus einem normalleitenden Deckmetall der Dicke d6 als eine Schutz- und/oder Kontaktschicht, die auch aus mehreren Lagen bestehen kann, welche miteinander in innigem Kontakt stehen,

sowie

7 der Leiteraufbau aus diesen vier Teilen.

Dabei kann man diese Teile wie folgt ausbilden:

- Ein metallisches Substratband 3 aus Ni, Ni-Legierungen oder Edelstahl mit einer Dicke d3 von etwa 20 bis 250 μm,
- eine Pufferschicht oder ein Pufferschichtensystem aus einer oder mehreren Lagen von Oxiden wie CeO$_2$ oder YSZ mit einer Dicke d4 von etwa 0,1 μm bis 1 mm,
- eine HTS-Schicht 5 aus YBCO mit einer Dicke d5 zwischen etwa 0,3 und 3 μm, und
- eine metallische Deckschicht 6 aus Ag, Au oder Cu mit einer Dicke d6 zwischen etwa 0,1 und 1 μm.

Ein entsprechender Bandleiter ist einige Millimeter bis wenige Zentimeter breit. Seine supraleitende Stromfähigkeit wird von der YBCO-Schicht 5, d.h. von deren kritischer Stromdichte bestimmt, während die thermischen, mechanischen und normalleitenden Eigenschaften wegen der größeren Dicke d3 von dem Substratband 3 und der Deckschicht 6 dominiert werden. Dabei bildet das Substratband zusammen mit der Pufferschicht eine Unterlage für ein quasi einkristallines Wachstum des YBCO. Substratbandmaterial und Pufferschichtmaterial dürfen im thermischen Ausdehnungskoeffizienten und in ihren kristallographischen Gitterkonstanten nicht zu weit vom YBCO abweichen. Je besser die Anpassung desto höher ist die rissfreie Schichtdicke und desto besser die Kristallinität des YBCO. Darüber hinaus ist für hohe kritische Stromdichten im MA/cm$^2$-Bereich eine möglichst parallele Ausrichtung der Kristallachsen in benachbarten Kristalliten gewünscht. Dies erfordert eine eben solche Ausrichtung zumindest in der obersten Pufferschicht, damit das YBCO heteroepitaktisch aufwachsen kann. Die Präparation solcher quasi einkristalliner flexibler Substrat-Puffersysteme gelingt bevorzugt mit drei Verfahren:

- Sogenanntes "Ion Beam Assisted Deposition (IBAD)" von meist YSZ oder MgO auf untexturierten Metallbändern,
- sogenannte "Inclined Substrate Deposition (ISD)" von YSZ oder MgO auf untexturierten Metallbändern,
- sogenannte "Rolling Assisted Biaxially Textured Substrates (RABiTS)", d.h. durch Walz- und Glühbehandlung in Würfellage gebrachte Substrate mit heteroepitaktischem Puffersystem.

Die auf dem Substratband abzuscheidenden Funktionsschichten 4 bis 6 werden in an sich bekannter Weise mit Vakummbeschichtungsverfahren (PVD), chemischer Abscheidung aus der Gasphase (CVD) oder aus chemischen Lösungen (CSD) hergestellt.

Selbstverständlich können zwischen den einzelnen Schichten des Leiteraufbaus 7 noch vergleichsweise dünnere, sich bei der Herstellung des Aufbaus bzw. bei der Abscheidung der einzelnen Schichten insbesondere auf Grund von Diffusionsvorgängen ausbildende Zwischenschichten vorhanden sein.

Im Vergleich zu den für YBCO-Dünnschicht-Strombegrenzer bekannten keramischen Plattenleitern ist bei Bandleitern des vorstehend geschilderten Typs das Substratband 3 elektrisch leitfähig, d.h. es kann daher den begrenzten Strom tragen und als Shunt wirken. Bei dem vorstehend in Figur 3 angedeuteten Leiteraufbau 7 wären jedoch die HTS-Schicht 5 und das Substratband 3 im Normalfall über die mindestens eine Pufferschicht 4 voneinander isoliert. Sobald die Strombegrenzereinrichtung in ihren begrenzenden Zustand übergeht, d.h. normalleitend wird und sich eine Spannung längs der Leiterbahn aufbaut, wird die Durchschlagsfeldstärke der bekannten Pufferschichtmaterialien, die in der Größenordnung von 100 kV/mm = 10 V/0,1 $\mu$m liegen, schnell überschritten. D.h., die Pufferschicht 4 würde dann unkontrolliert durchschlagen. Auf Grund dieser Problematik wird vorteilhaft ein hinreichend guter elektrischer Kontakt zwischen der Supraleitungsschicht 5 und dem metallischen Substratband 3 bevorzugt auf der ganzen Leiterlänge für den Einsatz von Bandleitern in der erfindungsgemäßen Strombegrenzereinrichtung vorgesehen. Hierzu sind bevorzugt die nachfolgend erläuterten Ausgestaltungen des Leiteraufbaus 7 nach Figur 3 möglich.

Gemäß einer ersten Ausgestaltungsmöglichkeit wird die wenigstens eine Pufferschicht 4 derart ausgebildet, dass zwischen der supraleitenden Schicht 5 und dem Substratband 3 zumindest in Teilbereichen, quasi in inselartigen Bereichen, bevorzugt aber über die gesamte gemeinsame Ausdehnung eine für einen Potentialausgleich zwischen der supraleitenden Schicht 5 und dem Substratband 3 hinreichende elektrische Leitfähigkeit gegeben ist. Dies lässt sich insbesondere dadurch erreichen, dass zwischen der YBCO-Schicht 5 und dem Substratband 3 ein Übergangswiderstand von höchstens $10^{-3}\ \Omega\cdot cm^2$, bevorzugt von höchstens $10^{-5}\ \Omega\cdot cm^2$, gegeben ist. Ein entsprechender Übergangswiderstand lässt sich insbesondere dann einstellen, wenn man für das Material der Pufferschicht 4 ein solches wählt, das einen mittleren spezifischen Widerstand von höchstens 5000 $\mu\Omega\cdot cm$, vorzugsweise von höchstens 500 $\mu\Omega\cdot cm$ aufweist. Entsprechende Materialien, die auch bzgl. der kristallinen Abmessungen des YBCO-Materials angepasst sind, sind La-Mn-O oder Sr-Ru-O oder La-Ni-O oder In-Sn-O (das sogenannte "ITO")

Gemäß einer zweiten Ausgestaltungsmöglichkeit wird von außen am oder um den Leiteraufbau 7 eine durchgängige Kontaktierung über die ganze Länge des Leiters 2 vorgesehen. Dabei ist der in Figur 3 gezeigte Leiteraufbau 7 an wenigstens einer Längsseite mit einem besonderen Kontaktierungselement ausgestattet. Dieses Kontaktierungselement besteht aus einem elektrisch gut leitenden Material wie aus Au, Ag oder Cu oder einer Legierung mit dem jeweiligen chemischen Element. Dem Kontaktierungselement kommt die Aufgabe zu, eine galvanische Verbindung zwischen der supraleitenden Schicht 5 und der elektrisch mit ihr verbundenen normalleitenden Deckschicht 6 einerseits und dem unteren normalleitenden Substratband 3 andererseits an der jeweiligen Längsseite bzw. -kante zu gewährleisten. Auf diese Weise liegen diese Teile bei jedem Betriebszustand der Strombegrenzereinrichtung wegen der gegenseitigen galvanischen Verbindung auf demselben elektrischen Potential.

Vorteilhaft wird der Materialquerschnitt des mindestens einen Kontaktierungselement so bemessen, dass dieses praktisch nicht als elektrischer Shunt für den begrenzten Strom wirkt. Dies ist durch die Materialwahl und/oder die mittlere Dicke des Kontaktierungselementes zu gewährleisten. Für die Bemessungsregel gilt vorteilhaft:

$$R_K > 3 \cdot R_L \text{ , vorzugsweise } R_K > 10 \cdot R_L \text{ .}$$

Dabei ist $R_L$ der elektrische Widerstand des gesamten Leiteraufbaus 7 ohne Kontaktierungselement, gemessen über die gesamte Länge der Leiterbahn. Der Widerstand $R_L$ setzt sich dabei aus einer Parallelschaltung des Widerstandes des Substratbandes 3, der Deckschicht 6 sowie des maximal möglichen Widerstandes der supraleitenden Schicht 5 im Falle deren Normalleitung zusammen. $R_K$ ist Widerstand aller parallel geschalteten Kontaktierungselemente über die diese Gesamtlänge.

Der Wert $R_K$ lässt sich in bekannter Weise durch die Materialwahl für das wenigstens eine Kontaktierungselement bzw. des elektrischen spezifischen Widerstandes $\rho_K$ seines Materials sowie durch die Dicke $d_K$ bzw. den zur Verfügung gestellten elektrisch leitenden Querschnitts einstellen.

Unter Berücksichtigung der vorerwähnten Beziehung liegt die Dicke $d_K$ im Allgemeinen unter 1 μm, vorzugsweise unter 0,5 μm.

Beispielsweise sind Kontaktierungselemente mittels Lötverfahren an den Seiten des Leiteraufbaus 7 anzubringen. Dabei kann selbstverständlich das jeweilige Kontaktierungselement auch ein Stück weit die obere Flachseite der Deckschicht 6 und/ oder die untere Flachseite des Substratbandes 3 mit abdecken.

Gemäß Figur 4 ist es auch möglich und besonders vorteilhaft, wenn das wenigstens eine Kontaktierungselement als ein den Leiteraufbau 7 allseitig umschließendes Umhüllungselement 9 ausgebildet ist. Ein entsprechendes Umhüllungselement kann beispielsweise aus einem normalleitenden Drahtgeflecht oder einer Drahtumwicklung oder aus einer Drahtumspinnung oder als ein Drahtvlies erstellt sein. Statt Drähten können selbstverständlich für diesen Zweck auch Bänder vorgesehen werden. Besonders vorteilhaft lässt sich ein umhüllendes Kontaktierungselement 9 auch mittels eines galvanischen Beschichtungsvorgangs erstellen. Entsprechende Schichten mit der geringen Dicke $d_K$ in der vorerwähnten Größenordnung sind auf einfache Weise und insbesondere ohne Beeinträchtigung der supraleitenden Eigenschaften der supraleitenden Schicht 5 auszubilden.

Gemäß einer dritten Ausgestaltungsmöglichkeit wird zumindest in Teilbereichen wenigstens einer der Seitenkanten des Leiteraufbaus 7 des Leiters 2 eine andere Kontaktierung vorgenommen, und zwar wird mittels einer mechanischen Deformation des Aufbaus wie z.B. mittels einer entsprechenden Quetsch- oder Walzverformung in diesem Bereich der Aufbau so verformt, dass sich die Deckschicht 6 und das Substratband 3 in elektrischem Kontakt befinden. Eine Verformung in diesen Bereichen ist im Allgemeinen unproblematisch, weil dort die supraleitenden Eigenschaften der Supraleitungsschicht 5 gegenüber einem mittleren Bereich des Leiters häufig verschlechtert sind.

Gemäß Figur 5 kann man beispielsweise mit Hilfe von Kantenrollen 21 und 22 die gewünschte Verformung vornehmen. Die Rollen wirken dabei auf die jeweiligen Seitenkanten in den Seitenbereichen 20a und/oder 20b derart ein, dass der Aufbau von dort aus in etwa diagonaler Richtung zusammengedrückt wird. Dabei wird das Deckschichtmaterial an das mechanisch robustere Substratband herangedrückt, so dass zumindest in Teilbereichen der Längsseite des Leiterbandes eine galvanische Verbindung zwischen dem metallischen Material der Deckschicht 6 und dem metallischen Material des Substratbandes 3 geschaffen wird.

Selbstverständlich ist es auch möglich, die vorstehend erläuterten Varianten zur Kontaktierung der YBCO-Schicht 5 mit ihrer darauf befindlichen, in innigem elektrischen Kontakt stehenden Deckschicht 6 einerseits und dem metallischen Substratband 3 andererseits miteinander gleichzeitig zur Anwendung zu bringen.

Bei den vorstehenden Ausführungsbeispielen wurde YBCO als HTS-Material für die supraleitende Schicht 5 zugrunde gelegt. Selbstverständlich sind auch andere HTS-Materialien vom sogenannten 1-2-3-Typ mit anderen Seltenen Erdmetallen und/oder anderen Erdalkalimetallen einsetzbar. Die einzelnen Komponenten dieser Materialien können auch in an sich bekannter Weise teilweise durch weitere/andere Komponenten substituiert sein.

**Patentansprüche**

1. Supraleitende Strombegrenzereinrichtung vom resistiven Typ, wobei
   deren Leiterbahn mit einem bandförmigen Supraleiteraufbau (7) gebildet ist, dessen oxidisches Hoch-$T_c$-Supraleitermaterial vom Typ $AB_2Cu_3O_x$ als Schicht (5) auf einem Substratband (3) aus einem normalleitendem Substratmetall aufgebracht ist, wobei A mindestens ein Seltenes Erdmetall einschließlich Yttrium und B mindestens ein Erdalkalimetall sind,

   - der Supraleiteraufbau (7) wenigstens eine zwischen dem Substratband (3) und der supraleitenden Schicht (5) angeordnete Pufferschicht (4) aus einem oxidischen Puffermaterial enthält, und
   - die Leiterbahn der supraleitenden Strombegrenzereinrichtung als eine bifilare Spule (11) ausgebildet ist, wobei zwischen benachbarten Spulenwindungen (12i) wenigstens ein für ein Kühlmittel (K) transparenter Abstandshalter (14) angeordnet ist, wobei
   - zwischen benachbarten Spulenwindungen (12i) ein Abstand (a) eingehalten ist, der von dem Kühlmittel (K) durchströmbar ist, und
   - der Supraleiteraufbau (7) eine auf der supraleitenden Schicht (5) aufgebrachte Deckschicht (6) aus einem normalleitenden Deckmetall enthält,

   **dadurch gekennzeichnet, dass**

   - wenigstens eine elektrische Kontaktierung zwischen der Deckschicht (6) und dem Substratband (3) vorgesehen ist und
   - die Spule (11) mit dem Supraleiter (2) und dem wenigstens einen Abstandshalter (14) eigenstabil ausgebildet ist, indem eine Verklebung zwischen diesen Teilen (2, 14) in gegenseitigen Berührungsbereichen vorgesehen ist.

2. Strombegrenzereinrichtung nach Anspruch 1, **dadurch gekennzeichnet, dass** in der Spule (11) der Supraleiter (2) mit seiner Substratbandseite nach außen angeordnet ist.

3. Strombegrenzereinrichtung nach Anspruch 1 oder 2, **dadurch gekennzeichnet, dass** in der Spule (11) zwischen dem Abstandshalter (14) und dem jeweils benachbarten Substratband (3) des Supraleiters (2) eine Isolationsfolie (17) angeordnet ist.

4. Strombegrenzereinrichtung nach einem der vorangehenden Ansprüche, **dadurch gekennzeichnet, dass** der Abstandshalter (14) als wenigstens eine wellenförmige Abstandsfolie ausgebildet ist.

5. Strombegrenzereinrichtung nach einem der vorangehenden Ansprüche, **dadurch gekennzeichnet, dass** die Supraleiter (2) der Spule (11) und die Abstandshalter (14) mittels eines Kunstharzes unter Freihaltung von Kühlmittelwegen miteinander verklebt sind.

6. Strombegrenzereinrichtung nach einem der vorangehenden Ansprüche, **dadurch gekennzeichnet, dass** der gegenseitige Abstand (a) der Spulenwindung (12i) mindestens 1 mm beträgt.

7. Strombegrenzereinrichtung nach einem der vorangehenden Ansprüche, **dadurch gekennzeichnet, dass** die Deckschicht (6) aus mehreren Lagen aus metallischem Material zusammengesetzt ist.

8. Strombegrenzereinrichtung nach einem der vorangehenden Ansprüche, **dadurch gekennzeichnet, dass** die Pufferschicht (4) aus mehreren Lagen aus verschiedenen oxidischen Materialien zusammengesetzt ist.

9. Strombegrenzereinrichtung nach einem der vorangehenden Ansprüche, **dadurch gekennzeichnet, dass** wenigstens ein Kontaktierungselement aus einem normalleitenden Kontaktierungsmaterial zumindest an einer Längsseite des Aufbaus (7) des Supraleiters (2) zwischen der Deckschicht (6) und dem Substratband (3) versehen ist, wobei für den normalleitenden Begrenzungszustand der Strombegrenzereinrichtung die Beziehung gilt:

$$R_K > 3 \cdot R_L$$

mit $R_L$ als dem elektrischen Widerstand des Aufbaus (7) ohne Kontaktierungselement über die Gesamtlänge der Leiterbahn und mit $R_K$ als dem Widerstand des wenigstens einem Kontaktierungselementes über die Gesamtlänge.

10. Strombegrenzereinrichtung nach Anspruch 9, **dadurch gekennzeichnet, dass** die Beziehung gilt:

$$R_K > 10 \cdot R_L .$$

11. Strombegrenzereinrichtung nach Anspruch 9 oder 10, **dadurch gekennzeichnet, dass** die durchschnittliche Dicke ($d_K$) des wenigstens einen Kontaktierungselementes unter 1 $\mu$m, vorzugsweise unter 0,5 $\mu$m liegt.

12. Strombegrenzereinrichtung nach einem der Ansprüche 9 bis 11, **dadurch gekennzeichnet, dass** als Material des wenigstens einen Kontaktierungselementes Au oder Ag oder Cu oder eine Legierung mit dem jeweiligen Element vorgesehen ist.

13. Strombegrenzereinrichtung nach einem der Ansprüche 9 bis 12, **gekennzeichnet durch** wenigstens ein mittels Lötverfahrens angebrachtes oder erzeugtes Kontaktierungselement.

14. Strombegrenzereinrichtung nach einem der Ansprüche 9 bis 13, **dadurch gekennzeichnet, dass** das Kontaktierungselement als ein den Leiteraufbau (7) allseitig umschließendes Umhüllungselement (9) ausgebildet ist.

15. Strombegrenzereinrichtung nach Anspruch 14, **gekennzeichnet durch** eine galvanische Beschichtung als Umhüllungselement.

**16.** Strombegrenzereinrichtung nach einem der Ansprüche 1 bis 8, **dadurch gekennzeichnet, dass** zumindest in Teilbereichen wenigstens eine der Seitenkanten des Leiteraufbaus (7) so mechanisch deformiert ist, dass sich die Deckschicht (6) und das Substratband (3) in elektrischem Kontakt befinden.

**17.** Strombegrenzereinrichtung nach Anspruch 16, **dadurch gekennzeichnet, dass** der elektrische Kontakt an der wenigstens einen Seitenkante durch eine Quetsch- oder Walzverformung gebildet ist.

**18.** Strombegrenzereinrichtung nach einem der vorangehenden Ansprüche, **dadurch gekennzeichnet, dass** die wenigstens eine Pufferschicht (4) derart ausgebildet, dass zwischen der supraleitenden Schicht (5) und dem Substratband (3) zumindest in Teilbereichen eine für einen Potentialausgleich zwischen der supraleitenden Schicht (5) und dem Substratband (3) hinreichende elektrische Leitfähigkeit gegeben ist.

**19.** Strombegrenzereinrichtung nach Anspruch 18, **dadurch gekennzeichnet, dass** für das Material der Pufferschicht (4) ein solches gewählt ist, dass ein Übergangswiderstand von höchstens $10^{-3}\,\Omega\cdot cm^2$, vorzugsweise von höchstens $10^{-5}\,\Omega\cdot cm^2$, ausgebildet ist.

**20.** Strombegrenzereinrichtung nach Anspruch 18 oder 19, **dadurch gekennzeichnet, dass** das Material der Pufferschicht (4) einen mittleren spezifischen Widerstand von höchstens 5000 $\mu\Omega\cdot cm$, vorzugsweise von höchstens 500 $\mu\Omega\cdot cm$, aufweist.

**21.** Strombegrenzereinrichtung nach einem der Ansprüche 18 bis 20, **dadurch gekennzeichnet, dass** für das Material der Pufferschicht (4) ein oxidisches Material vom Typ La-Mn-O oder Sr-Ru-O oder La-Ni-O oder In-Sn-O gewählt ist.

**Claims**

**1.** Superconducting current-limiter device of the resistive type, in which

- its conductor track is formed by a superconductor structure (7) in the form of a strip, whose oxidic high-$T_c$ superconductor material of the $AB_2Cu_3O_x$ type is applied as a layer (5) to a substrate strip (3) composed of a normally conductive substrate metal, with A being at least one rare earth metal including yttrium, and B being at least one alkiline earth metal,
- the superconductor structure (7) contains at least one buffer layer (4), which is arranged between the substrate strip (3) and the superconducting layer (5) and is composed of an oxidic buffer material, and
- the conductor track of the superconducting current-limiter device is in the form of a bifilar coil (11), with at least one spacer (14) which is transparent for a coolant
(K), being arranged between adjacent coil turns (12i),

in which

- a distance (a) through which the coolant (K) can flow is maintained between adjacent coil turns (12i), and
- the superconductor structure (7) contains a covering layer (6), which is applied to the superconducting layer (5) and
is composed of a normally conductive covering metal,

**characterized in that**

- at least one electrical contact is provided between the covering layer (6) and the substrate strip (3), and
- the coil (11) together with the superconductor (2) and the at least one spacer (14) are designed to be intrinsically stable, in which adhesive bonding is provided between these parts (2, 14) in regions that are in contact with one another.

**2.** Current-limiter device according to Claim 1, **characterized in that** the superconductor (2) is arranged with its substrate strip side on the outside in the coil (11).

**3.** Current-limiter device according to Claim 1 or 2,
**characterized in that** an insulation film (17) is arranged in the coil (11), between the spacer (14) and the respectively adjacent substrate strip (3) of the superconductor (2).

**4.** Current-limiter device according to one of the preceding claims, **characterized in that** the spacer (14) is in the form of at least one corrugated spacing film.

**5.** Current-limiter device according to one of the preceding claims, **characterized in that** the superconductor (2) in the coil (11) and the spacers (14) are adhesively bonded to one another by means of a synthetic resin, leaving coolant paths free.

**6.** Current-limiter device according to one of the preceding claims, **characterized in that** the mutual separation (a) between the coil turns (12i) is at least 1 mm.

**7.** Current-limiter device according to one of the preceding claims, **characterized in that** the covering layer (6) is composed of a plurality of layers of metallic material.

**8.** Current-limiter device according to one of the preceding claims, **characterized in that** the buffer layer (4) is composed of a plurality of layers of different oxidic materials.

**9.** Current-limiter device according to one of the preceding claims, **characterized in that** at least one contact-making element composed of a normally conductive contact-making material is provided between the covering layer (6) and the substrate strip (3) on at least one longitudinal side of the configuration (7) of the superconductor (2), with the normally conductive limiting state of the current-limiter device being governed by the relationship:

$$R_K > 3 \cdot R_L$$

where $R_L$ is the electrical resistance of the configuration (7) without the contact-making element over the entire length of the conductor track, and $R_K$ is the resistance of the at least one contact-making element over the entire length.

**10.** Current-limiter device according to Claim 9, **characterized in that** the relationship is:

$$R_K > 10 \cdot R_L.$$

**11.** Current-limiter device according to Claim 9 or 10,
**characterized in that** the average thickness ($d_K$) of the at least one contact-making element is less than 1 $\mu$m, preferably less than 0.5 $\mu$m.

**12.** Current-limiter device according to one of Claims 9 to 11, **characterized in that** gold, silver, copper or an alloy with the respective element is provided as the material for the at least one contact-making element.

**13.** Current-limiter device according to one of Claims 9 to 12, **characterized by** at least one contact-making element which is applied or produced by means of a soldering process.

**14.** Current-limiter device according to one of Claims 9 to 13, **characterized in that** the contact-making element is in the form of a sheathing element (9) which surrounds the conductor configuration (7) on all sides.

**15.** Current-limiter device according to Claim 14, **characterized by** an electrochemical coating as the sheathing element.

**16.** Current-limiter device according to one of Claims 1 to 8, **characterized in that**, at least in subareas, at least one of the side edges of the conductor configuration (7) is mechanically deformed such that the covering layer (6) and the substrate strip (3) make electrical contact.

**17.** Current-limiter device according to claim 16, **characterized in that** the electrical contact on the at least one side edge is formed by crushing or rolling deformation.

**18.** Current-limiter device according to one of the preceding claims, **characterized in that** the at least one buffer layer (4) is formed in such a manner that it results in an electrical conductivity between the superconducting layer (5) and the substrate strip (3), at least in subareas, which is sufficient for potential equalization between the superconducting layer (5) and the substrate strip (3).

19. Current-limiter device according to Claim 18, **characterized in that** the material of the buffer layer (4) is chosen such that it results in a contact resistance of at most $10^{-3}$ $\Omega \cdot cm^2$, preferably of at most $10^{-5}$ $\Omega \cdot cm^2$.

20. Current-limiter device according to Claim 18 or 19,
**characterized in that** the material of the buffer layer (4) has a mean resistivity of at most 5000 $\mu\Omega \cdot cm$, preferably of at most 500 $\Omega \cdot cm^2$.

21. Current-limiter device according to one of Claims 18 to 20, **characterized in that** an oxidic material of the La-Mn-O, Sr-Ru-O, La-Ni-O or In-Sn-0 type is chosen for the material of the buffer layer (4).

**Revendications**

1. Limiteur de courant supraconducteur du type résistif, dans lequel,

- sa piste conductrice est formée par une structure (7) supraconductrice en forme de ruban, dont le matériau supraconducteur oxydé à $T_c$ haut, du type $AB_2Cu_3O_x$, est déposé sous forme de couche sur un ruban (3) formant substrat en un métal de substrat normalement conducteur, A étant au moins un métal de terre rare, y compris de l'Ittrium et B au moins un métal alcalino-terreux.
- la structure (7) supraconductrice comporte au moins une couche (4) tampon en un matériau tampon oxydé, disposé entre le ruban (3) formant substrat et la couche (5) supraconductrice, et
- la piste conductrice du limiteur de courant supraconducteur est constituée sous la forme d'une bobine (11) bifilaire, au moins une entretoise (14) transparente pour un fluide (K) de refroidissement étant disposée entre des spires (12i) voisines de la bobine, dans lequel
- entre deux spires (12i) de la bobine est maintenu un intervalle (a) dans lequel le fluide (K) de refroidissement peut passer, et
- la structure (7) supraconductrice comporte une couche (6) de recouvrement en un métal de recouvrement normalement conducteur, déposée sur la couche (5) supraconductrice,

**caractérisé en ce que**

- il est prévu au moins une mise en contact électrique entre la couche (6) de recouvrement et le ruban (3) formant substrat et
- la bobine (11) est constituée de manière à avoir une stabilité propre avec le supraconducteur (2) et la au moins une entretoise (14), en prévoyant un collage entre ces pièces (2, 14) dans des parties de contact mutuelles.

2. Limiteur de courant supraconducteur suivant la revendication 1, **caractérisé en ce** dans la bobine (11) le supraconducteur (12) est disposé vers l'extérieur par son côté de ruban formant substrat.

3. Limiteur de courant supraconducteur suivant la revendication 1 ou 2, **caractérisé en ce que** dans la bobine (11) une feuille (17) isolante est disposée entre l'entretoise (14) et le ruban (3) respectivement voisin et formant substrat du supraconducteur (2).

4. Limiteur de courant supraconducteur suivant l'une des revendications précédentes, **caractérisé en ce que** l'entretoise (14) est constituée sous la forme d'au moins une feuille d'entretoise ondulée.

5. Limiteur de courant supraconducteur suivant l'une des revendications précédentes, **caractérisé en ce que** le supraconducteur (2) de la bobine (11) et les entretoises (14) sont collées entre elles au moyen d'une résine de matrice plastique synthétique en maintenant dégagé des chemins pour du fluide de refroidissement.

6. Limiteur de courant supraconducteur suivant l'une des revendications précédentes, **caractérisé en ce que** l'intervalle

(a) mutuel entre les spires (12i) de la bobine est d'au moins 1 mm.

**7.** Limiteur de courant supraconducteur suivant l'une des revendications précédentes, **caractérisé en ce que** la couche (6) de recouvrement est composée de plusieurs strates en matériau métallique.

**8.** Limiteur de courant supraconducteur suivant l'une des revendications précédentes, **caractérisé en ce que** la couche (4) tampon est composée de plusieurs strates en matériaux oxydés différents.

**9.** Limiteur de courant supraconducteur suivant l'une des revendications précédentes, **caractérisé en ce qu'**au moins un élément de mise en contact en un matériau de mise en contact normalement conducteur est prévu au moins sur un grand côté de la structure (7) du supraconducteur (2) entre la couche (6) de recouvrement et le ruban (3) formant substrat, en ayant pour l'état de limitation en conduction normale du dispositif limiteur de courant la relation $R_K > 3 . R_L$. $R_L$ étant la résistance électrique de la structure (7) sans l'élément de mise en contact sur toute la longueur de la piste conductrice et $R_K$ étant la résistance du au moins un élément de contact sur toute la longueur.

**10.** Limiteur de courant supraconducteur suivant la revendication 9, **caractérisé en ce que** l'on a la relation $R_K > 10 . R_L$.

**11.** Limiteur de courant supraconducteur suivant la revendication 9 ou 10, **caractérisé en ce que** l'épaisseur ($d_K$) moyenne du au moins un élément de mise en contact est inférieur à $1 \mu m$, de préférence inférieure à $0,5 \mu m$.

**12.** Limiteur de courant supraconducteur suivant l'une des revendications 9 à 11, **caractérisé en ce qu'**il est prévu comme matériau du au moins un élément de mise en contact Au ou Ag ou Cu ou un alliage ayant l'élément respectif.

**13.** Limiteur de courant supraconducteur suivant l'une des revendications 9 à 12, **caractérisé par** au moins un élément de mise en contact produit ou déposé au moyen d'un procédé de brasure.

**14.** Limiteur de courant supraconducteur suivant l'une des revendications 9 à 13, **caractérisé en ce que** l'élément de mise en contact est constitué sous la forme d'un élément (9) d'enrobage entourant de tout côté la structure (7) conductrice.

**15.** Limiteur de courant supraconducteur suivant la revendication 14, **caractérisé par** un revêtement galvanique en tant qu'élément d'enrobage.

**16.** Limiteur de courant supraconducteur suivant l'une des revendications 1 à 8, **caractérisé en ce qu'**au moins dans certaines parties au moins l'un des bords latéraux de la structure (7) conductrice est déformée mécaniquement de sorte que la couche (6) de recouvrement et le ruban (3) formant substrat se trouvent en contact électrique.

**17.** Limiteur de courant supraconducteur suivant la revendication 16, **caractérisé en ce que** le contact électrique est formé sur le au moins bord latéral par déformation, par pincement ou par laminage.

**18.** Limiteur de courant supraconducteur suivant l'une des revendications précédentes, **caractérisé en ce que** la au moins une couche (4) tampon est constituée de manière à ce qu'il y ait entre la couche (5) supraconductrice et le ruban (3) formant substrat au moins dans certaines parties une conductivité électrique suffisante pour une compensation de potentiel entre la couche (5) supraconductrice et le ruban (3) formant substrat.

**19.** Limiteur de courant supraconducteur suivant la revendication 18, **caractérisé en ce qu'**on choisit pour le matériau de la couche (4) tampon un matériau tel qu'il se forme une résistance de contact d'au plus $10^{-3} \Omega \cdot cm^2$, de préférence d'au plus $10^{-5} \Omega \cdot cm^2$.

**20.** Limiteur de courant supraconducteur suivant la revendication 18 ou 19, **caractérisé en ce que** le matériau de la couche (4) tampon a une résistance spécifique moyenne d'au plus 5000 $\mu\Omega \cdot cm$ de préférence d'au plus 500 $\mu\Omega \cdot cm$.

**21.** Limiteur de courant supraconducteur suivant la revendication 18 ou 20, **caractérisé en ce que** l'on choisit pour le matériau de la couche (4) tampon un matériau oxydé du type La-Mn-0 ou Sr-Ru-0 ou La-Ni-O ou In-Sn-O.

# FIG 1

# FIG 2

## FIG 3

## FIG 4

## FIG 5

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 9933122 A
- EP 0292959 A1
- EP 0503448 A
- WO 0010208 A